Europäisches Patentamt

**European Patent Office**

Office européen des brevets

(11) Veröffentlichungsnummer: **0 007 396**

**B1**

(12) **EUROPÄISCHE PATENTSCHRIFT**

(21) Anmeldenummer: **79101577.9**

(22) Anmeldetag: **22.05.79**

(51) Int. Cl.³: **F 24 F 3/00, F 24 F 3/14, F 24 F 11/08, H 05 K 7/20**

(54) Kühleinrichtung für in geschlossenen Gehäusen angeordnete elektrische Baueinheiten.

(30) Priorität: **28.06.78 DE 2828374**

(43) Veröffentlichungstag der Anmeldung:
**06.02.80 Patentblatt 80/3**

(45) Bekanntmachung des Hinweises auf die Patenterteilung:
**25.03.81 Patentblatt 81/12**

(84) Benannte Vertragsstaaten:
**AT BE CH FR GB IT NL**

(56) Entgegenhaltungen:
**DD - A - 103 959**
**DE - A - 2 142 151**
**DE - U - 7 709 175**
**GB - A - 1 363 292**

**SIEMENS ZEITSCHRIFT, Band 46, Heft 8, 1972**
**P. FRIES et al. "Wärmeaustauscher zur Verlust-**
**wärmeabfuhr aus staubdichten Elektronik-**
**schränken" Seite 699 bis 702**

(73) Patentinhaber: **SIEMENS AKTIENGESELLSCHAFT**
**Berlin und München**
**Postfach 22 02 61**
**D-8000 München 22 (DE)**

(72) Erfinder: **Geldsetzer, Paul, Dipl.-Ing.**
**Sollner Strasse 52**
**D-8000 München 71 (DE)**
(72) Erfinder: **Gräf, Johann**
**Memlingstrasse 6**
**D-8000 München 71 (DE)**
(72) Erfinder: **Lange, Klaus**
**Euckenstrasse 40**
**D-8000 München 70 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

## Kühleinrichtung für in geschlossenen Gehäusen angeordnete elektrische Baueinheiten

Die Erfindung bezieht sich auf eine Kühleinrichtung für in geschlossenen Gehäusen übereinander angeordnete, Wärme erzeugende elektrische Baueinheiten mit einem geschlossenen, durch ein Lüfteraggregat erzwungenen Kühlluftstrom, in dem ein Luft/Flüssigkeits-Wärmetauscher angeordnet ist, der zusammen mit den Lüfteraggregaten unterhalb oder überhalb der Baueinheiten in den Baueinheitenblock integriert ist, wobei der Kühlluftstrom in freier Verteilung im sonst vorzugsweise für Kabelzuführungen verwendeten offenen Raum zwischen den Gehäusewänden und den Baueinheiten zurückgeführt ist.

Größere elektronische Geräte bestehen vielfach aus einer Mehrzahl von Baueinheiten, z.B. mehreren elektonischen Steuerungseinheiten und einer für diese gemeinsam vorgesehen Stromversorgungseinheit. Insbesondere sind diese Baueinheiten jeweils aus einer Mehrzahl von Schaltungsplatten zusammengesetzt, auf denen elektrische Bauteile montiert sind. In einer solchen Baueinheit sind diese Schaltungsplatten, vertikal stehend, parallel zueinander angeordnet. Bei elektronischen Geräten hoher Packungsdichte ist es vielfach üblich, die zwischen den einzelnen Schaltungsplatten einer Baueinheit notwendigen Leitungsverbindungen, sowie von außen kommende Signal- bzw. Potentialanschlüsse an die Schaltungsplatten über eine Verdrahtungsplatte zu führen, die eine der Stirnseiten der Baueinheit bildet. Solche Baueinheiten eines elektronischen Gerätes werden üblicherweise übereinandergesetzt und in ein Gehäuse eingesetzt, dessen Inneres für Montage- und Wartungsarbeiten durch eine abnehmbare Abdeckung, bei großen Schränken durch eine Tür zugänglich ist.

Mit wachsender Packungsdichte der elektronischen Bauelemente auf den Schaltungsplatten der Baueinheiten und einer dichteren Verdrahtung der einzelnen Schaltungsplatten untereinander ist die Verlustleistung bezogen auf das Volumen der elektronischen Geräte erheblich gestiegen. Im Zuge dieser Entwicklung mußte mehr und mehr dazu übergegangen werden, größere elektronische Geräte zwangsweise zu kühlen, um diese Verlustleistung sicher abzuführen und im Betrieb noch zulässige Temperaturen an den elektrischen, insbesondere den elektronischen Bauelementen einzuhalten. Bei geringeren Anforderungen wird bisher die benötigte Kühlluft aus dem Raum bezogen, in dem das elektronische Gerät aufgestellt ist und die erwärmte Luft wieder in diesen Raum abgegeben. In Sonderfällen werden geschlossene Kühlsysteme verwendet, bei denen die im elektronischen Gerät erwärmte Kühlluft in einem eigenen Luft-Rückführungskanal dem elektronischen Gerät wieder zugeführt wird. Hier muß der erwärmten Kühlluft durch Luft/Flüssigkeits-Wärmetauscher oder durch großflächige Luft/Luft-Wärmetauscher die der Verlustleistung entsprechende Wärmemenge entzogen werden.

Die erstgenannten Systeme haben den Nachteil, das Raumklima erheblich zu beeinträchtigen und erfordern daher aufwendige Lösungen für die Klimatisierung solcher Räume. Trotzdem stören die umgewälzten Luftmengen. Weiterhin muß die eintretende Kühlluft in der Regel nochmals vorgekühlt werden, was aber eine Erhöhung der relativen Feuchte der Kühlluft am Geräteeinlaß bedeutet. Dies beeinträchtigt auch die elektrische Sicherheit der Geräte, ist jedoch vor allem Ursache für Korrosionserscheinungen. Dies läßt sich nur verhindern, wenn die relative Feuchte der eingetretenen Kühlluft kontinuierlich abgesenkt wird, da fortlaufend neue Luftmassen zugeführt werden. Das erfordert dann, das ständig in größerer Menge anfallende Kondenswasser laufend abzuführen. Die kontinuierliche Entfeuchtung ist daher sehr aufwendig.

Bei geschlossenen Systemen wird dagegen fortlaufend dieselbe Luftmenge in dem geschlossenen Kreislauf umgewälzt, so daß solche Entfeuchtungsprobleme nicht auftreten. Hier stören allerdings die bei elektronischen Geräten mit hoher Packungsdichte zum Abführen der Verlustleistung notwendigen Luftmengen, die große Querschnitte für die Rückführungskanäle erfordern.

In der DE-A-2 142 151 ist eine Kühlanordnung beschrieben, bei der der Luftstrom rund um die Baueinheiten herum erzeugt wird, so daß beispielsweise die Luft in dem Raum zwischen dem Baueinheitenturm und der einen Seitenwand des Gehäuses auf- und zwischen dem Baueinheitenturm und der anderen Seite des Gehäuses abwärts geführt ist. Mit einer derartigen Anordnung kann jedoch keine so intensive Kühlung erreicht werden, wie sie insbesondere für integrierte Schaltungen in der Datentechnik notwendig ist.

Aufgabe der Erfindung ist es, die bekannte Kühleinrichtung für die integrierten Baueinheiten in der Weise zu verbessern, daß eine intensive Kühlung erreicht wird, wobei eine unerwünschte Kondensatbildung innerhalb der Baueinheiten vermieden ist.

Erfindungsgemäß wird diese Aufgabe bei einer Kühleinrichtung der eingangs genannten Art durch die im Kennzeichen des Hauptanspruches beschriebenen Merkmale gelöst. Diese Lösung nützt in besonders vorteilhafter Weise zwei konstruktive Gegebenheiten im Aufbau sehr dicht gepackter elektronischer Geräte aus: Die einzelnen Baueinheiten sind, bedingt durch den die Schaltungsplatten tragenden Raum, an ihren Schmalseiten normalerweise an sich schon abgeschlossen oder können leicht abgedeckt werden, und eine der Stirnseiten ist vielfach auch bereits durch eine großflächige Verdrahtungsplatte abgedeckt. So ist schließlich nur die zweite Stirnseite noch getrennt abzudecken. Dies läßt sich einfach durch Dichtleisten erreichen, die beispielsweise an der Vorderkante der Schaltungsplatte aufgesetzt sind. Die oben und unten für den Luftaustausch- bzw. den Lufteintritt offenen Baueinheiten bilden dann, wenn man sie übereinandersetzt, einen Luftkanal, der mit wenig Aufwand gegenüber der Umgebung abzuschließen ist. In diesem Luftkanal stehen die Schaltungsplatten mit den zu kühlenden Bauelementen, die so unmittelbar von der Kühlluft umströmt werden. Die zweite vorgegebene konstruktive Eigenschaft elektronischer Geräte besteht darin, daß zwischen den Gehäusewänden und den Baueinheiten an sich bereits freie Räume notwendig sind, um dort Stromversorgungsleitungen oder Signalkabel verlegen zu können. Da die Baueinheiten zusammen mit dem Lüfteraggregat und dem Luft/Flüssigkeits-Wärmetauscher einen Block mit geschlossenen Seitenwänden bilden, kann in diesen freien Räumen zwischen den Wänden des Gehäuses und des Baueinheitenblocks auch die Kühlluft zur Lufteintrittsseite des Baueinheitenblocks zurückgeführt werden. Konstruktiv aufwendige und voluminöse getrennte Kanäle zur Rückführung der Kühlluft sind nicht mehr erforderlich.

Sind die Schrankwände thermisch abgedichtet, dann ist das Schrankinnere weitgehend von der Geräteumgebung entkoppelt, so daß die Lufttemperatur im Gehäuseinnenraum über die Kühlflüssigkeitstemperatur in weiten Bereichen frei wählbar ist. In diesem geschlossenen System ist das Problem der relativen Feuchte der Kühlluft bei weitem nicht so groß wie bei den bekannten offenen Systemen, so daß ein in dem rückgeführten Kühlluftstrom angeordneter Entfeuchter genügt, um mit Sicherheit Korrosionserscheinungen zu vermeiden. Der Entfeuchter kann dabei so in den Kühlflüssigkeitskreislauf einbezogen sein, daß er mit niedrigerer Temperatur als der Luft/Flüssigkeits-Wärmeaustauscher von der Kühlflüssigkeit durchflossen wird.

Wie in Unteransprüchen beschriebene Weiterbildungen der Erfindung zeigen, läßt sich diese Lösung auch in einfacher Weise derart ergänzen, daß die in der Praxis durch Abheben von Gehäuseabdeckungen oder das Öffnen einer Schranktür gelegentlich aufgehobene Entkopplung von der Geräteumgebung für das Innenraumklima ohne Bedeutung bleibt. Um zu vermeiden, daß dann bei einer sehr niedrigen Temperatur der Kühlflüssigkeit und/oder bei ungünstigen Raumverhältnissen an dem Luft/Flüssigkeits-Wärmetauscher Betauung auftritt, wird die Temperatur der Kühlflüssigkeit im Wärmetauscher in solchen Fällen angehoben. Dazu ist eine Kurzschlußleitung zwischen dem Kühlflüssigkeitsrücklauf und dem -vorlauf vorgesehen, in die z.B. durch Türkontakte betätigte Regelventile eingeschaltet sind. Damit ist der Kühlflüssigkeitsrücklauf kurzzuschließen, so daß sich das Kühlmittel selbsttätig aufheizt. Dieser Vorgang kann durch ein weiteres, thermostatisch geregeltes Regelventil zumindestens teilweise aufgehoben werden, sobald die Kühlflüssigkeit ein vorgegebene Temperatur erreicht.

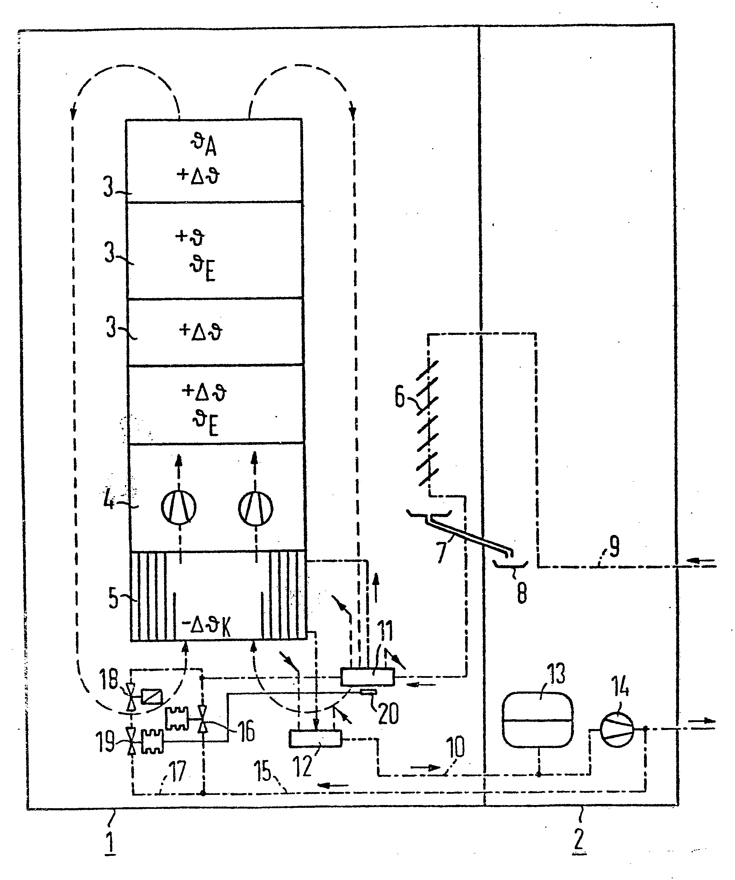

Im folgenden wird die Erfindung anhand eines Ausführungsbeispieles näher erläutert. Dazu ist in der Zeichnung der prinzipielle Aufbau eines Geräteschrankes mit einer erfindungsgemäß ausgebildeten Kühleinrichtung dargestellt.

Die in der Zeichnung dargestellte Schrankeinheit setzt sich aus einem Geräteschrank 1 und einer Anbaueinheit 2 zusammen. Im Inneren des Geräteschrankes 1 ist eine Säule von übereinandergestellten elektronischen Baueinheiten 3 schematisch angedeutet. Diese sollen mit geschlossenen Seitenwänden als Block einen Kühlluftkanal bilden, in den ein Lüferaggregat 4 und ein Luft/Flüssigkeits-Wärmetauscher 5 integriert ist. Das Lüfteraggregat, hier unter den elektrischen Baueinheiten 3 angeordnet, setzt zwangsweise einen Kühlluftstrom durch die elektrischen Baueinheiten 3 in Gang, der in der Zeichnung mit gestrichelten Linien angedeutet ist. An der Eintrittsseite dieses Kühlluftstroms ist ein Luft/Flüssigkeits-Wärmetauscher 5 angeordnet, der aus der den Baueinheiten 3 zuzuführenden Kühlluft Wärme entzieht, was in der Zeichnung durch die Temperaturdifferenz — $\Delta\vartheta_k$ angedeutet ist. Die so abgekühlte Luft wird durch das Lüfteraggregat 4 angesaugt und durch die Baueinheiten 3 gedrückt. Dabei nimmt sie in jeder der Baueinheiten unterschiedliche Wärmemengen auf, so daß sich ihre Temperatur beim Durchfluss durch eine Baueinheit um unterschiedliche Temperaturdifferenzen $+\Delta\vartheta$ erhöht. Die oben mit einer Temperatur $\vartheta_A$ aus dem Baueinheitenblock austretende Luft wird in den zwischen dem Baueinheitenblock und den Seitenwänden des Geräteschranks 1 verbleibenden Räumen zum Luft/Flüssigkeits-Wärmeaustauscher 5 zurückgeführt. In diesem geschlossenen Kühlluftsystem muß die Leistung des Luft/Flüssigkeits-Wärmetauschers 5 ausreichend bemessen sein, damit die Beziehung:

$$\Delta\vartheta_k \cong \Sigma\Delta\vartheta$$

zu erfüllen ist.

Dieses Lüftungssystem soll von der Geräteumgebung weitgehend entkoppelt sein. Dazu ist es nicht notwendig, den Geräteschrank vollständig thermisch zu isolieren, da ein Wärmedurchgang durch die Schrankwände weniger schadet als ein Luftdurchtritt. Dieser soll vor allem deshalb vermieden werden weil das Raumklima im Schrankinneren eine verhältnismäßig niedrige relative Feuchte besitzen soll. Bei zu hoher relativer Feuchte der umgewälzten Kühlluft könnte sich am Luft/Flüssigkeits-Wärmetauscher 5 ein unerwünschtes Kondensat niederschlagen. Um dies mit Sicherheit zu vermeiden, ist in den Rückstrom der erwärmten Kühlluft ein Kondensator 6 eingefügt. Er kann jedoch nur dann richtig arbeiten, wenn er innerhalb des Geräteschranks den Kältepol darstellt. Er ist deshalb unmittelbar auf der Eingangsseite des Kühlflüssigkeitskreislaufs für den Luft/Flüssigkeits-Wärmetauscher 5 angeordnet, wirkt selbst als solcher und gibt an die Kühlflüssigkeit die freiwerdende Kondensationswärme ab. Das Kondensat wird aufgefangen, über eine Kondensatleitung 7 aus dem Geräteschrank 1 abgeleitet und einer Verdunstungsschale 8 zugeführt, die beispielsweise mit großflächigen, saugfähigen Stoffen gefüllt ist und bei hohem Kondensatanfall zusätzlich beheizbar sein kann.

Der Luft/Flüssigkeits-Wärmetauscher 5 liegt in einem Kühlflüssigkeitskreislauf, der in der Zeichnung mit strichpunktierten Linien angedeutet ist. In diesem sind allerdings an sich bekannte Einrichtungen zum Aufbereiten der Kühlflüssigkeit mit weiteren Wärmetauschern, Verdampfern und Kondensatoren nicht mehr dargestellt. Dargestellt ist jedoch der Kühlflüssigkeitsvorlauf 9, der die Kühlflüssigkeit dem Luft/Flüssigkeits-Wärmetauscher 5 zuführt und der Kühlflüssigkeitsrücklauf 10, der die erwärmte Kühlflüssigkeit aus dem Luft/Flüssigkeits-Wärmetauscher 5 abführt.

In diese Leitungsstränge ist je ein Vorlaufverteiler 11 bzw. ein Rücklaufverteiler 12 eingefügt. Damit ist angedeutet, daß der Luft/Flüssigkeits-Wärmetauscher 5 auch in mehrere Teileinheiten, die z.B. in unterschiedlicher Höhe in den Baueinheitenblock integriert sind, unterteilt sein kann. Dies ist z.B. dann zweckmäßig, wenn die Austrittstemperatur $v_A$ der Kühlluft aus einer Baueinheit bereits so hoch ist, daß dann die darüber liegende Baueinheit 3 nicht mehr ausreichend gekühlt werden kann. Solche Verteiler sind aber auch dann notwendig, wenn in einem Geräteschrank 1 mehrere Baueinheitenblöcke angeordnet und damit auch getrennt zu kühlen sind.

Um Volumenänderungen bei unterschiedlichen Temperaturen der erwärmten Kühlflüssigkeit zu berücksichtigen, ist in der Anbaueinheit 2 an den Kühlflüssigkeitsrücklauf 10 ein Ausdehnungsgefäß 13 angeschlossen. Schließlich ist in den Kühlflüssigkeitsrücklauf eine ebenfalls in der Anbaueinheit 2 untergebrachte Umwälzpumpe eingeschaltet, die eine ausreichende Durchlaufmenge der Kühlflüssigkeit sicherstellt.

Um die Kühleinrichtung ausreichend flexibel an unterschiedliche Gerätetypen oder auch unterschiedliche Umgebungsbedingungen anpassen zu können, muß die Leistung des Luft/Flüssigkeits-Wärmetauschers 5 entsprechend der abzuführenden Wärmemenge regelbar sein. Dies wird durch entsprechendes Beimischen erwärmter Kühlflüssigkeit aus dem Kühlflüssigkeitsrücklauf 10 zur kalten Kühlflüssigkeit im Kühlflüssigkeitsvorlauf 9 erreicht. Dazu ist eine Kurzschlußleitung 15 hinter der Umwälzpumpe 14 angeschlossen und zum Vorlaufverteiler 11 geführt. In diese Kurzschlußleitung 15 ist ein erstes thermostatisch gesteuertes Regelventil 16 eingeschaltet, das abhängig von der Lufttemperatur im Schrankinnenraum die Durchflußmenge durch die Kurzschlußleitung 15 steuert. Mit diesem Regelventil kann in weiten Grenzen eine definierte Innentemperatur im Geräteschrank 1 eingestellt werden.

Für den praktischen Betrieb ist jedoch zu berücksichtigen, daß die Baueinheiten 3 z.B. für Wartungsarbeiten auch im Betriebszustand zugänglich sein müssen und dafür im Geräteschrank 1 normalerweise eine Tür vorgesehen ist. Bei geöffneter Tür ist das Kühlluftsystem im Schrankinneren nicht mehr von der Umgebung entkoppelt. Sind tiefe Schranktemperaturen eingestellt, kann der Luft/Flüssigkeits-Wärmetauscher 5 bei ungünstigen Umgebungsverhältnissen als Kondensationsfläche wirken. Um dies zu verhindern, ist parallel zu dem ersten Regelventil 16, mit dem eine definierte Schranktemperatur aufrechterhalten wird, eine Nebenschlußleitung 17 vorgesehen. In diese sind zwei weitere Regelventile 18 bzw. 19 eingefügt. Das zweite Regelventil 18 ist — wie in der Zeichnung angedeutet — durch einen Türkontakt magnetisch zu betätigen und öffnet die Nebenschlußleitung 17, sobald die Schranktür geöffnet wird. Über die Nebenschlußleitung 17 und den Vorlaufverteiler 11 wird dann dem Luft/Flüssigkeits-Wärmetauscher 5 eine erhöhte Menge erwärmter Kühlflüssigkeit aus dem Kühlflüssigkeitsrücklauf zugeführt. Um diesen Vorgang bei einer bestimmten Temperatur zumindest abbremsen zu können, ist das dritte thermostatisch gesteuerte Regelventil 19 vorgesehen, das mit einem Temperaturfühler 20 abhängig von der Temperatur im Vorlaufverteiler 11 bei einer bestimmten Temperatur zugesteuert wird und damit die Durchflußmenge in der Nebenschlußleitung 17 reduziert.

**Patentansprüche**

1. Kühleinrichtung für in geschlossenen Gehäusen übereinander angeordnete, Wärme erzeugende elektrische Baueinheiten (3) mit einem geschlossenen, durch ein Lüfteraggregat (4) erzwungenen Kühlluftstrom, in dem ein Luft/Flüssigkeits-Wärmetauscher (5) angeordnet ist, der zusammen mit den Lüfteraggregaten (4) unterhalb oder oberhalb der Baueinheiten (3) in den Baueinheitenblock integriert ist, wobei der Kühlluftstrom in freier Verteilung im sonst vorzugsweise für Kabelzuführungen verwendeten offenen Raum zwischen den Gehäusewänden und den Baueinheiten zurückgeführt ist, dadurch gekennzeichnet, daß die elektrischen Baueinheiten (3) allseitig geschlossene Seitenflächen aufweisen und in ihrem Inneren einen Kanal für den aufwärts bewegten Kühlluftstrom bilden, und daß in dem offenen Raum in rückströmenden Kühlluftstrom Einrichtungen (6) zum Kondensieren der Feuchtigkeit im Kühlluftstrom angeordnet sind.

2. Kühleinrichtung nach Anspruch 1, dadurch gekennzeichnet, daß der Luft/Flüssigkeits-Wärmetauscher (5) auf der Saugseite des Lüfteraggregats (4) angeordnet ist.

3. Kühleinrichtung nach Anspruch 1, dadurch gekennzeichnet, daß der Luft/Flüssigkeits-Wärmetauscher (5) auf der Druckseite des Lüfteraggregats (4) angeordnet ist.

4. Kühleinrichtung nach Anspruch 1, dadurch gekennzeichnet, daß der Luft-Flüssigkeits-Wärmetauscher (5) in mehrere Einzelelemente unterteilt ist, die in verschiedener Höhe des Blocks von Baueinheiten (3) angeordnet sind.

5. Kühleinrichtung nach einem der Ansprüche 1 bis 4, dadurch gekennzeichnet, daß in den Kreislauf der Kühlflüssigkeit des Luft/Flüssigkeits-Wärmetauschers (5) Regelventile (16, 18 bzw. 19) zum Steuern der Leistung des Luft/Flüssigkeits-Wärmetauschers eingeschaltet sind.

6. Kühleinrichtung nach Anspruch 5, dadurch gekennzeichnet, daß die Regelventile (16, 18 bzw. 19) in eine Kurzschlußleitung (15) zwischen dem Kühlflüssigkeitsrücklauf (10) und dem Kühlflüssigkeitsvorlauf (9) derart eingeschaltet sind, daß die Regelung der Leistung des Luft/Flüssigkeits-Wärmetauschers (5) durch Beimischung erwärmter Kühlflüssigkeit aus dem Kühlflüssigkeitsrücklauf in den Kühlflüssigkeitvorlauf erfolgt.

7. Kühleinrichtung nach Anspruch 6, dadurch gekennzeichnet, daß bei einem Betrieb mit einer unterhalb der Umgebungstemperatur liegenden Innentemperatur Regelventile (18, 19) vorgesehen sind, die beim Öffnen einer Schranktür auslösbar sind und dabei dem Kühlflüssigkeitsvorlauf (9) so viel erwärmte Kühlflüssigkeit aus dem Kühlflüssigkeitsrücklauf (10) beimischen, daß die Temperatur des Luft/Flüssigkeits-Wärmetauschers (5) über den Taupunkt der Umgebungstemperatur angehoben wird.

8. Kühleinrichtung nach Anspruch 7, dadurch gekennzeichnet, daß die Regelung der Leistung des Luft/Flüssigkeits-Wärmetauschers (5) bei geöffneter Schranktür auf einen festen Wert eingestellt ist.

9. Kühleinrichtung nach Anspruch 7, dadurch gekennzeichnet, daß die Regelung der Leistung des Luft/Flüssigkeits-Wärmetauschers (5) bei geöffneter Schranktür in Abhängigkeit von Temperatur und relativer Feuchte der Umgebungsluft erfolgt.

10. Kühleinrichtung nach einem der Ansprüche 1 bis 9, dadurch gekennzeichnet, daß zum Ableiten des sich an den Einrichtungen (6) zum Kondensieren der Feuchtigkeit im Kühlluftstrom niederschlagenden Wassers aus dem Schrankinneren eine Kondensatleitung (7) vorgesehen ist, die an eine auf der Schrankaußenseite angeordnete Verdunstungseinrichtung (8) angeschlossen ist.

**Claims**

1. Cooling device for electrical components (3) which are superimposed in sealed housings and generate heat, with a closed cooling air flow which is forced by a fan aggregate (4) and in which an air/liquid heat exchanger (5) is arranged, which heat exchanger is integrated into the component block beneath and above the components (3) together with the fan aggregates (4), wherein the cooling air flow is returned in free distribution in the area between the walls of the housing and the components which is usually open and preferably used for cable supplies characterised in that the electrical components (3) have side faces closed all-round and form a channel for the cooling air flow moving upwards in their interior, and that in the open area, in the path of the returning cooling air flow, there are arranged devices (6) for condensing the moisture in the cooling air flow.

2. Cooling device as claimed in Claim 1, characterised in that the air/liquid heat exchanger (5) is arranged on the suction side of the fan aggregate (4).

3. Cooling device as claimed in Claim 1, characterised in that the air/liquid heat exchanger (5) is arranged on the pressure side of the fan aggregate (4).

4. Cooling device as claimed in Claim 1, characterised in that the air/liquid heat exchanger (5) is divided into a plurality of individual elements which are arranged at different levels of the block components (3).

5. Cooling device as claimed in one of Claims 1 to 4, characterised in that regulating valves (16, 18 and 19) for controlling the output of the air/liquid heat exchanger are inserted into the cycle of the cooling liquid of the air/liquid heat exchanger (5).

6. Cooling device as claimed in Claim 5, characterised in that the regulating valves (16, 18 and 19) are inserted into a short-circuit line (15) between the cooling liquid reverse flow (10) and the cooling liquid outgoing flow (9) in such manner that the regulation of the output of the air/liquid heat exchanger (5) is effected by the addition of heated cooling liquid from the cooling liquid reverse flow into the cooling liquid outgoing flow.

7. Cooling device as claimed in Claim 6, characterised in that when operating at an inner temperature which lies below the ambient temperature there are provided regulating valves (18, 19) which can be rendered operative when opening a cupboard door and add so much heated cooling liquid from the cooling liquid reverse flow (10) to the cooling liquid forward flow (9) that the temperature of the air/liquid heat exchanger (5) is raised above the dew point of the ambient temperature.

8. Cooling device as claimed in Claim 7, characterised in that the regulation of the output of the air/liquid heat exchanger (5) with open cupboard door is adjusted to a fixed value.

9. Cooling device as claimed in Claim 7, characterised in that the regulation of the output of the air/liquid heat exchanger (5) with open cupboard door is effected in dependence upon temperature and relative moisture of the ambient air.

10. Cooling device as claimed in one of the Claims 1 to 9, characterised in that for draining off the water from the inside of the cupboard, which water condenses at the devices (6) for condensing the moisture in the cooling air flow, there is provided a condensation line (7) which is connected to an evaporation device (8) arranged on the outside of the cupboard.

**Revendications**

1. Installation de refroidissement pour des modules électriques (3) disposés les uns au-dessus des autres dans des boîtiers fermés et dégageant de la chaleur, du type comportant un circuit d'air de refroidissement forcé obtenu par un agrégat de ventilation (4) et dans lequel est monté un èchangeur de chaleur air/liquide (5) qui est intégré, avec les agrégats de ventilation (4), au-dessous ou au-dessus des modules (3), dans le bloc de modules, tandis que le courant d'air de refroidissement est renvoyé, suivant une distribution libre, dans un espace ouvert, utilisé par ailleurs de préférence pour le passage de câbles, et situé entre les parois du boîtier et les modules, caractérisé par le fait que les modules électriques (3) comportent des surfaces latérales fermées de tous côtés et forment, en leur intérieur, un canal pour l'écoulement d'air de refroidissement se deplaçant suivant un mouvement ascendant, et que des dispositifs (6) permettant de condenser l'humidité dans l'écoulement d'air de refroidissement sont disposés, dans l'espace ouvert pour l'écoulement d'air de refroidissement de retour.

2. Installation de refroidissement suivant la revendication 1, caractérisée par le fait que l'échangeur de chaleur air/liquide (5) est disposé du côté aspiration de l'agrégat de ventilation (4).

3. Installation de refroidissement suivant la revendication 1, caractérisée par le fait que l'échangeur de chaleur air/liquide (5) est monté sur le côté refoulement de l'agrégat de ventilation (4).

4. Installation de refroidissement suivant la revendication 1, caractérisée par le fait que l'échangeur de chaleur air/liquide (5) est subdivisé en plusieurs éléments individuels qui sont disposés à des hauteurs variables de modules (3).

5. Installation de refroidissement suivant l'une des revendications 1 à 4, caractérisée par le fait que des vannes de régulation (16, 18 et 19) permettant de commander la puissance de l'échangeur de chaleur air/liquide sont montées dans le circuit du liquide de refroidissement de l'échangeur de chaleur air/liquide (5).

6. Installation de refroidissement suivant la revendication 5, caractérisée par le fait que les vannes de régulation (16, 18 et 19) sont montées dans une canalisation de court-circuit (15 s'étendant entre le circuit de retour (10) et le circuit aller (9) du liquide de refroidissement, de telle manière que la régulation de la puissance de l'échangeur de chaleur air/liquide (5) s'effectue au moyen d'une adjonction de liquide de refroidissement échauffé provenant du circuit de retour du liquide de refroidissement dans le circuit aller du liquide de refroidissement.

7. Installation de refroidissement suivant la revendication 6, caractérisée par le fait que, dans le cas d'un fonctionnement avec une température intérieure inférieure à la température ambiante, il est prévu des vannes de régulation (18, 19) qui peuvent être actionnés lors de l'ouverture d'une porte d'armoire et qu'au circuit aller (9) du liquide de refroidissement est ajoutée une quantité telle de liquide de refroidissement chauffé provenant du circuit de retour (10) du liquide de refroidissement, que la température de l'échangeur de chaleur air/liquide (5) est élevée au-dessus du point de condensation de la température ambiante.

8. Installation de refroidissement suivant la revendication 7, caractérisée par le fait que la régulation de la puissance de l'échangeur de chaleur air/liquide (5) est réglée à une valeur fixe lorsque la porte de l'armoire est ouverte.

9. Installation de refroidissement suivant la revendication 7, caractérisée par le fait que la régulation de la puissance de l'échangeur de chaleur air/liquide (5) s'effectue en fonction de la température et de l'humidité relative de l'air environnant, lorsque la porte de l'armoire est ouverte.

10. Installation de refroidissement suivant l'une des revendications 1 à 9, caractérisée par le fait que pour évacuer de l'intérieur de l'armoire l'eau qui se dépose au niveau des dispositifs (6) pour condenser l'humidité dans l'écoulement d'air de refroidissement, il est prévu une canalisation (7) de collecte du condensat, qui est raccordée à un dispositif "évaporation (8) monté sur la face extérieure de l'armoire.